Europäisches Patentamt

European Patent Office

Office européen des brevets

(11) Veröffentlichungsnummer: **0 245 763**
A2

# EUROPÄISCHE PATENTANMELDUNG

(21) Anmeldenummer: 87106551.2

(22) Anmeldetag: 06.05.87

(51) Int. Cl.³: **H 03 K 17/687**

(30) Priorität: 13.05.86 DE 3616097

(43) Veröffentlichungstag der Anmeldung:
19.11.87 Patentblatt 87/47

(84) Benannte Vertragsstaaten:
DE FR GB

(71) Anmelder: BROWN, BOVERI & CIE Aktiengesellschaft
Kallstadterstrasse 1
D-6800 Mannheim(DE)

(72) Erfinder: Bertsch, Bruno, Dipl.-Ing.
Siedlerstrasse 63
D-6830 Schwetzingen(DE)

(72) Erfinder: Ebert, Reinhold, Dipl.-Ing.
Weinbergstrasse 6a
D-6100 Darmstadt(DE)

(74) Vertreter: Rupprecht, Klaus, Dipl.-Ing. et al,
c/o BROWN, BOVERI & CIE AG Postfach 10 03 51
Zentralbereich Patente
D-6800 Mannheim 1(DE)

(54) Schaltungsanordnung zur Ansteuerung von Leistungs-Feldeffekttransistoren.

(57) Diese Schaltungsanordnung dient vorzugsweise zur potentialgetrennten, dynamischen, leistungsstarken, parallelen Ansteuerung einer Vielzahl von Leistungs-Feldeffekttransistoren (24). Die Zündsignale (Z) werden mittels monostabiler Kippglieder (1 bzw. 2,3) begrenzt bzw. zu Kurzimpulsen umgeformt und über Hilfstransistoren (7,8) einem als Gegentaktwandler arbeitenden Übertrager (12) zugeführt. Die Sekundärwicklungen (11, 12) des Übertragers (10) sind jeweils über Zenerdioden (14,15; 18,19) mit Treibertransistoren (16,20) beschaltet, wobei die Steuerelektrode (G) des Leistungs-Feldeffekttransistors (24) über den einen Treibertransistor (16) mit positiver Spannung (U+) und über den weiteren Treibertransistor (20) mit negativer Spannung oder Massepotential (U0) beaufschlagbar ist. Die eine Mittelanzapfung aufweisende Primärwicklung (9) des Übertragers (10) wird jeweils zur Hälfte mit Strömen entgegengesetzer Richtung beaufschlagt, je nachdem ob der Leistungs-Feldeffekttransistor (24) ein- oder auszuschalten ist.

Fig. 1

B R O W N , B O V E R I & C I E     AKTIENGESELLSCHAFT
Mannheim                             12. Mai 1986
Mp.Nr. 573/86                        ZPT/P3-Pn/Fo

## Schaltungsanordnung zur Ansteuerung von Leistungs-Feldeffekttransistoren

Die Erfindung bezieht sich auf eine Schaltungsanordnung zur Ansteuerung von Leistungs-Feldeffekttransistoren gemäß dem Oberbegriff des Anspruchs 1.

Eine solche Schaltungsanordnung zur Ansteuerung von Leistungs-Feldeffekttransistoren ist aus der DE-OS 32 12 320 bekannt. Bei der dort beschriebenen Schaltungsanordnung ist jedem Leistungs-Feldeffekttransistor eine Ansteuereinheit vorgeschaltet, bestehend aus einem Übertrager mit Mittelanzapfung auf der Primärseite, einem Doppelweggleichrichter auf der Sekundärseite des Übertragers und einem die Gleichspannungspole des Gleichrichters überbrückenden ohmschen Entladewiderstand. Es ist eine zentrale Hilfsspannungsquelle vorgesehen, die gegenphasige Gleichspannungsimpulse auf die Zuleitungen zu den Enden der Primärwicklungen führt. Die Zuleitung zur Mittelanzapfung ist über einen elektronisch gesteuerten Schalter an eine Versorgungsspannung gelegt. Bei einer selektiven Ansteuerung mehrerer Lei-

0245763

stungs-Feldeffekttransistoren hat jeder Schalter einen eigenen Steuereingang. Diese bekannte Schaltung ist sehr aufwendig.

Der Erfindung liegt die Aufgabe zugrunde, eine Schaltungsanordnung zur Ansteuerung von Leistungs-Feldeffekttransistoren der eingangs genannten Art anzugeben, die ein dynamisches und leistungsstarkes Durchschalten ermöglicht und dabei einen einfachen Aufbau aufweist.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß die Schaltungsanordnung ein sehr schnelles und präzises Durchschalten und Sperren von Leistungs-Feldeffekttransistoren ermöglicht. Dabei ist die Schaltung selbst sehr kompakt aufgebaut und verbraucht nur wenig Verlustleistung. Weitere Vorteile sind aus der nachfolgenden Beschreibung ersichtlich.

Vorteilhafte Ausgestaltungen der Erfindung sind in den Unteransprüchen gekennzeichnet.

Die Erfindung wird nachstehend anhand des in den Zeichnungen dargestellten Ausführungsbeispieles erläutert.

Es zeigen:

Fig. 1    Die Ansteuerschaltung für Leistungs-Feldeffekttransistoren,

Fig. 2    ein Impulsdiagramm zur Ansteuerschaltung,

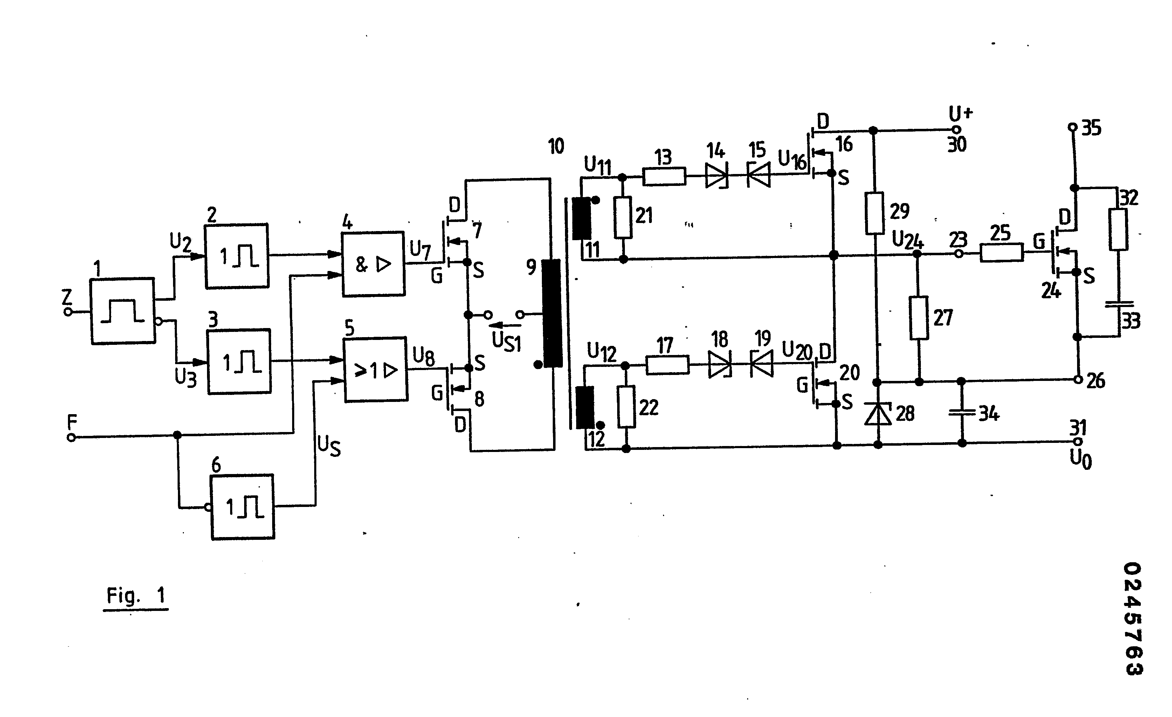

In der Figur 1 ist die Ansteuerschaltung für Leistungs-Feldeffekttransistoren im einzelnen gezeigt. Einem er-

0245763

sten monostabilen Kippglied 1 ist ein Zündsignal Z eingangsseitig zuführbar. Das Kippglied 1 dient zur Impulsbegrenzung und ist ausgangsseitig mit dem Eingang eines zweiten monostabilen Kippgliedes 2 und über einen invertierten Ausgang mit dem Eingang eines dritten monostabilen Kippgliedes 3 verbunden. Die Kippglieder 2 und 3 dienen zur Kurzimpulsformung. Der Ausgang des Kippgliedes 2 ist an den ersten Eingang eines UND-Gatters 4 (mit nachgeschaltetem Verstärker) angeschlossen, während der Ausgang des Kippgliedes 3 am ersten Eingang eines ODER-Gatters 5 (mit nachgeschaltetem Verstärker) liegt. Der zweite Eingang des UND-Gatters 4 ist mit einem Impulsfreigabesignal F direkt beaufschlägbar. Die Gatter 4,5 dienen zur Impulsverteilung. Das Impulsfreigabesignal F wird desweiteren dem negierten Eingang eines vierten monostabilen Kippgliedes 6 zugeleitet. Das Kippglied 6 dient zur Erzeugung eines Sperrimpulses. Der Ausgang des Kippgliedes 6 ist an den zweiten Eingang des ODER-Gatters 5 angeschlossen.

Der Ausgang des UND-Gatters 4 ist mit dem Gate-Anschluß G eines ersten Hilfstransistors 7 verbunden, während der Ausgang des ODER-Gatters 5 am Gate-Anschluß G eines zweiten Hilfstransistors 8 liegt. Der Drain-Anschluß D des Transistors 7 ist über eine Primärwicklung 9 eines Übertragers 10 mit dem Drain-Anschluß D des Transistors 8 verbunden. Die Source-Anschlüsse S der beiden Transistoren 7 und 8 sind zusammengeschaltet. Zwischen einer Mittelanzapfung der Primärwicklung 9 und dem gemeinsamen Source-Anschluß der Transistoren 7,8 liegt eine Versorgungsspannung $U_{S1}$ an.

Der Übertrager 10 weist zwei Sekundärwicklungen 11 und 12 mit entgegengesetztem Wicklungssinn auf. Der erste Anschluß der ersten Sekundärwickung 11 ist über einen Widerstand 13 und zwei mit ihren Kathoden

0245763

zusammengeschaltete, in Serie liegende Zenerdioden 14,15 mit dem Gate-Anschluß G eines Treibertransistors 16 verbunden. Der erste Anschluß der zweiten Sekundärwicklung 12 ist über einen Widerstand 17 und zwei mit ihren Kathoden zusammengeschaltete in Serie liegende Zenerdioden 18,19 mit dem Gate-Anschluß G eines Treibertransistors 20 verbunden. Die Transistoren 16,20 dienen als Endstufentreiber. Parallel zur Sekundärwicklung 11 bzw. 12 ist jeweils ein Widerstand 21 bzw. 22 angeordnet.

Der zweite Anschluß der Sekundärwicklung 11 bildet eine Klemme 23 für den Gate-Anschluß G eines Leistungs-Feldeffekttransistors 24. Vorzugsweise ist zwischen Gate-Anschluß G des Transistors 24 und Klemme 23 ein Widerstand 25 vorgesehen. Der Widerstand 25 dient hauptsächlich dazu, bei mehreren parallelgechalteten Leistungstransi - storen eine regelmäßige Stromverteilung zu erreichen und Schwingungen zu vermeiden. Hierzu ist jedem einzelnen Leistungstransistor ein eigner Widerstand 25 in der Gate-Zuleitung zugeordnet. Mit der Klemme 23 sind der Source-Anschluß S des Transistors 16, der Drain-Anschluß D des Transistors 20 sowie ein weiterer, andererseits an einer Klemme 26 liegender Widerstand 27 verbunden. An der Klemme 26 liegen desweiteren der Source-Anschluß S des Leistungs-Feldeffekttransistors 24, die Kathode einer Zenerdiode 28 sowie ein Widerstand 29. Außerdem dient Klemme 26 als Lastanschluß. Der Widerstand 27 dient hauptsächlich zur Entladung der Gate-Source-Kapazität bei abgeschaltetem Leistungs-Feldeffekttransistor 24.

Der Widerstand 29 ist andererseits mit einer Klemme 30 verbunden. An der Klemme 30 liegt ferner der Drain-Anschluß D des Transistors 16. Klemme 30 wird mit einer positiven Spannung $U_+$ beaufschlagt. Die Anode der Zenerdiode 28 ist mit einer Klemme 31 verbunden. Klemme
31 wird mit Massepotential $U_O$ beaufschlagt und führt zum
Source-Anschluß S des Transistors 20 sowie zum zweiten
Anschluß der Sekundärwicklung 12.

Zwischen dem Drain-Anschluß D und dem Source-Anschluß S
des Leistungs-Feldeffekttransistors 24 ist vorzugsweise
die Serienschaltung eines Widerstandes 32 und eines Kondensators 33 zur dU/dt-Begrenzung angeordnet. Parallel
zur Zenerdiode 28 ist ein Stützkondensator 34 geschaltet. Der Drain-Anschluß D des Leistungs-Feldeffekttransistors 24 ist mit einer Klemme 35 verbunden. An die
Klemme 35 ist der positive Pol einer Gleichspannungsquelle angeschlossen.

Der Anschluß einer Last (z.B. eines Motors) erfolgt zwischen der Klemme 26 und dem negativen Pol der Gleichspannungsquelle.

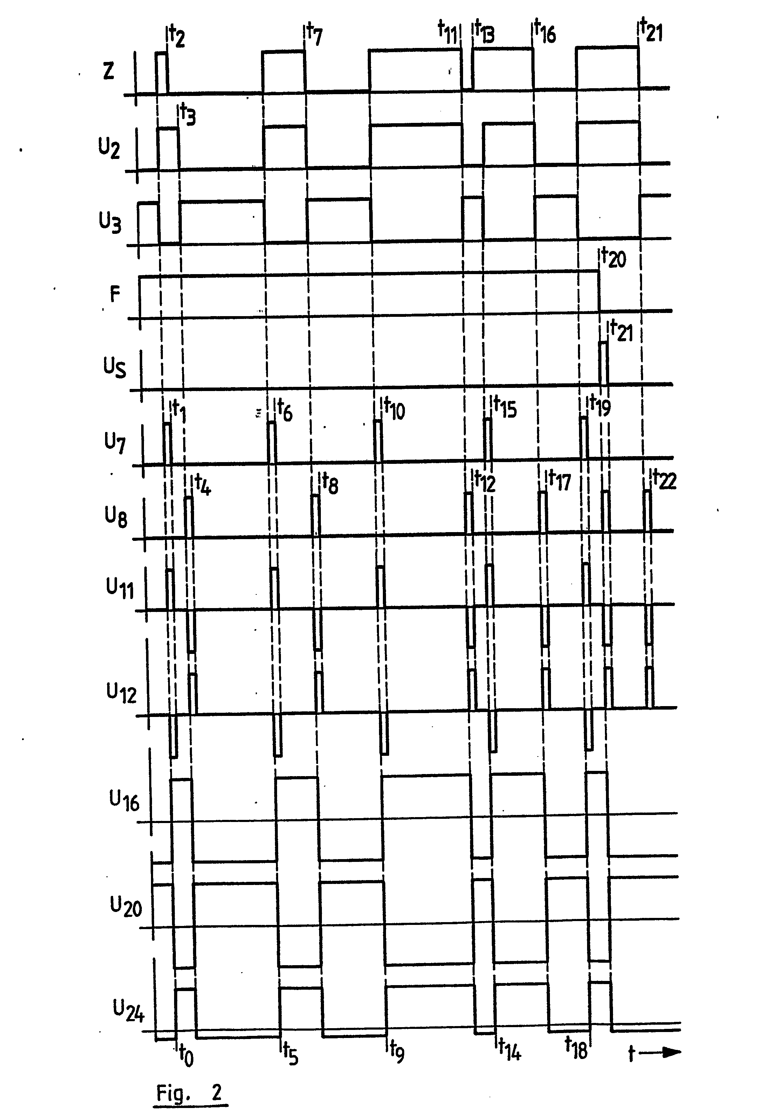

Nachfolgend wird die Funktionsweise der Ansteuerschaltung für Leistungs-Feldeffekttransistoren erläutert,
wobei auch auf das Impulsdiagramm nach Figur 2 verwiesen
wird. Beim Auftreten eines Zündimpulses Z (siehe Z zwischen $t_5$ und $t_7$ in Figur 2) wird das monostabile Kippglied 1 aktiviert und gibt ein 1-Signal an das monostabile Kippglied 2 ab (Langimpuls , siehe $U_2$ zwischen $t_5$
und $t_7$ in Figur 2). Hierdurch wird das Kippglied 2 ebenfalls aktiviert und gibt ein 1-Signal an das UND-Gatter
4 ab (Kurzimpuls). Bei gleichzeitigem Vorliegen (1-Signal) eines Impuls-Freigabesignals F schaltet das UND-
Gatters 4 durch und steuert damit den Gate-Anschluß G
des Hilfstransistors 7 durch Aufladen der Gate-Source-
Kapazität an (siehe $U_7$ zwischen $t_5$ und $T_6$). Die Source-
Drain-Strecke des Transistors 7 wird leitend und es ergibt sich ein durch die anliegende Versorgungsspannung
$U_{S1}$ verursachter Stromfluß über die Drain-Source-Strecke

0245763

des Transistors 7 und die obere Wicklungshälfte der Primärwicklung 9. Infolge des Stromes in der Primärwicklung 9 werden in der Sekundärwicklung 11 eine positive Spannung und in der Sekundärwicklung 12 eine negative Spannung induziert (siehe $U_{11}$ und $U_{12}$ zwischen $t_5$ und $t_6$). Die Spannung über der Sekundärwicklung 12 führt zur Entladung und zur negativen Aufladung der Gate-Source-Kapazität des Transsitors 20 und damit zum Sperren dieses Transistors (siehe $U_{20}$ zwischen $t_5$ und $t_7$).

Die Spannung über der Sekundärwicklung 11 bewirkt eine positive Aufladung der Gate-Source-Kapazität des Treibertransistors 16 über den Widerstand 13 und die beiden spannungsbegrenzenden Zehnerdioden 14, 15, so daß die Drain-Source-Strecke des Treibertransistors 16 leitend wird (siehe $U_{16}$ zwischen $t_5$ und $t_7$). Hierdurch wird die Gate-Source-Kapazität des Leistungs-Feldeffekttransistors 24 positiv aufgeladen, was zum Durchschalten des Leistungs-Feldeffekttransistors 24 führt (siehe $U_{24}$ zwischen $t_5$ und $t_7$).

Der Treibertransistor 16 und damit auch der Leistungs-Feldeffekttransistor 24 bleiben bis zum Auftreten einer negativen Spannung in der Sekundärwicklung 11 im betrachteten Frequenzbereich durchgeschaltet. Dies ergibt sich aus der Speicherfähigkeit der Gate-Source-Kapazität des Transistors 16 in Vebindung mit den beiden spannungsbegrenzenden Zehnerdioden 14, 15.

Vorzugsweise ist der ohmsche Widerstandswert des Widerstandes 17 kleiner als der des Widerstandes 13. Aufgrund der dadurch verursachten kleineren Verzögerungszeit wird der Transistor 20 schneller ausgeschaltet als der Transistor 16 eingeschaltet wird. Dies ist zur Vermeidung eines Kurzschlusses erforderlich.

0245763

Bei Verschwinden des Zündimpulses Z (siehe Z zum Zeitpunkt $t_7$) wird das Kippglied 6 aufgrund des negierten Ausganges des Kippgliedes 1 aktiviert (siehe $U_3$ zum Zeitpunkt $t_7$), gibt ein 1-Signal an das ODER-Gatter 5 ab (Kurzimpuls) und steuert damit den Gate-Anschluß G des Hilfstransistors 8 an (siehe $U_8$ zwischen $t_7$ und $t_8$). Die Drain-Source-Strecke des Transistors 8 wird leitend und es ergibt sich ein durch die anliegenden Versorgungsspannung $U_{S1}$ verursachter Stromfluß über die Drain-Source-Strecke des Transistors 8 und die untere Wicklungshälfte der Primärwicklung 9. Dieser Strom durchfließt die untere Hälfte der Primärwicklung 9 in entgegengesetzer Richtung im Vergleich zum Strom durch die obere Wicklungshälfte der Primärwicklung bei leitendem Hilfstransistor 7, d.h. die Richtung des magnetischen Flusses wird geändert. Infolge des Stromes in der Primärwicklung 9 werden in der Sekundärwicklung 11 eine negative Spannung und in der Sekundärwicklung 12 eine positive Spannung induziert (siehe $U_{11}$ und $U_{12}$ zwischen $t_7$ und $t_8$). Die Spannung über der Sekundärwicklung 12 bewirkt eine positive Aufladung der Gate-Source-Kapazität des Treibertransistors 20 über den Widerstand 17 und die beiden spannungsbegrenzenden Zenerdioden 18, 19, so daß die Drain-Source-Strecke des Treibertransitors 20 leitend wird (siehe $U_{20}$ zwischen $t_7$ und $t_9$). Hierdurch wird Massepotential $U_0$ an das Gate G des Feldeffekttransitors 24 gelegt, d.h. die Gate-Source-Kapazität des Transistors 24 wird entladen, was zum Sperren der Drain-Source-Strecke und somit zur Abschaltung des Laststromes führt (siehe $U_{24}$ zwischen $t_7$ und $t_9$).

Durch die aus der Zenerdiode 28, dem Stützkondensator 34 und dem Widerstand 29 bestehende Anordnung erhält der Source-Anschluß S des Leistungs-Feldeffekttransistors 24 eine positive Vorspannung gegenüber dem Massepotential. Die Gate-Source-Spannung des Leistungs-Feldeffekttransisitors 24 wird damit 0245763 während der Abschaltphase (negative Vorspannung für Leistungs-Transistor).

Die Widerstände 21 und 22 dienen als sekundäre Abschlußwiderstände zum Entmagnetisieren des Übertragers. Sie führen den Entmagnetisierungsstrom nach Beendigung eines Kurzimpulses, was primäre Überspannungen vermeidet.

Der infolge der in der Wicklung 11 induzierten negtiven Spannung über den Widerstand 13 fließende Umladestrom führt zur negativen Aufladung der Gate-Source-Kapazität und damit zum Sperren des Treibertransistors 16 (siehe $U_{16}$ zwischen $t_7$ und $t_9$).

Bei Verschwinden des Impulsfreigabesignales (siehe F zum Zeitpunkt $t_{20}$) gibt das monostabile Kippglied 6 einen Sperrimpuls $U_S$ an das ODER-Gatter 5 ab (siehe $U_S$ zwischen $t_{20}$ und $t_{21}$). Ohne Rücksicht darauf, daß im betrachteten Zeitraum noch das Zündsignal Z ansteht, steuert das ODER-Gatter 5 den Hilfstransistor 8 an (siehe $U_8$ zwischen $t_{20}$ und $t_{21}$). Folglich werden in der Wicklung 11 eine negative und in der Wicklung 12 eine positive Spannung induziert (siehe $U_{11}$ und $U_{12}$ zwischen $t_{20}$ und $t_{21}$). Daraufhin werden der Transistor 20 durchgesteuert und der Transistor 16 gesperrt (siehe $U_{16}$ und $U_{20}$ ab dem Zeitpunkt $t_{20}$), was zur Abschaltung des Leistungs-Feldeffekttransistors 24 führt (siehe $U_{24}$ ab Zeitpunkt $t_{20}$).

Allgemein dienen die Bauteile 11, 13, 14, 15, 16 in Verbindung mit den Bauteilen 2, 4, 7 als Einschaltkanal und die Bauteile 12, 17, 18, 19, 20 in Verbindung mit den Bauteilen 3, 5, 8 als hierzu komplimentärer Ausschaltkanal für den Leistungs-Feldeffekttransistor 24.

Die beschriebene Schaltungsordnung eignet sich vorzugs-weise zur parallelen Ansteuerung einer Vielzahl von MOS-FET.

In der Figur 2 ist ein Impulsdiagramm zur Ansteuerschaltung dargestellt. Im einzelnen sind das Zündsignal Z, das dem Kippglied 2 zugeführte Begrenzungssignal $U_2$ für einen Ein-Impuls (für den Leistungs-Feldeffekttransistor 24), das dem Kippglied 3 zugeführte, zu $U_2$ invertierte Begrenzungssignal $U_3$ für einen Aus-Impuls , das Impulsfreigabesignal F, das dem ODER-Gatter 5 zugeführte Sperr-impulssignal $U_S$, das dem Hilfstransistor 7 zgeführte Kurzimpulssignal $U_7$ für einen Ein-Impuls, das dem Hilfs-transistor 8 zugeführte Kurzimpulssignal $U_8$ für einen Aus-Impuls, das an der Wicklung 11 induzierte Gegentakt-wandler-Ausgangssignal $U_{11}$ für einen Ein-Impuls, das an der Wicklung 12 induzierte Gegentaktwandler-Ausgangssig-nal $U_{12}$ für einen Aus-Impuls, das dem Treibertransistor 16 anliegende Speichersignal $U_{16}$ für einen Ein-Impuls, das dem Treibertransistor 20 anliegende Speichersignal $U_{20}$ für einen Aus-Impuls und das Ansteuersignal $U_{24}$ für den Leistungs-Feldeffekttransistor 24 dargestellt.

Es ist zu erkennen, daß das Kippglied 1 bei zu kurzen Zündsignalen Z verlängerte Begrenzungssignale $U_2$ bzw. $U_3$ an die Kippglieder 2 bzw. 3 weitergibt (siehe Z, $U_2$, $U_3$ und Zeitpunkte $t_2$ und $t_3$). Bei einer zu kurzen Pause zwischen zwei aufeinanderfolgenden Zündsignalen Z wird die Pause vom Kippglied 1 verlängert (siehe Z, $U_2$, $U_3$ und Zeitpunkte $t_{13}$ und $t_{14}$). Das Kippglied 1 dient somit zur exakten Vorgabe einer minimalen Einschalt- bzw. Ausschaltdauer für den Leistungs-Feldeffekttransistor 24.

A n s p r ü c h e

1. Schaltungsanordnung zur Ansteuerung eines oder mehrerer Leistungs-Feldeffekttransistoren im Schaltbetrieb mit Potentialtrennung durch einen Übertrager, dadurch gekennzeichnet, daß ein Übertrager (10) mit zwei Sekundärwicklungen (11,12) von entgegengesetztem Wicklungssinn vorgesehen ist, wovon die erste Sekundärwicklung (11) an die Steuerelektrode (G) eines ersten, mit positiver Spannung ($U_+$) verbundenen Treibertransistors (16) und die zweite Sekundärwicklung (12) an die Steuerelektrode (G) eines zweiten, mit negativer Spannung oder Massepotential ($U_0$) verbundenen Treibertransistors (20) angeschlossen ist, daß die beiden Treibertransistoren (16,20) andererseits mit dem Gate (G) des Leistungs-Feldeffekttransistors (24) verbunden sind und daß die Primärwicklung (9) des Übertragers (10) mit Strömen entgegengesetzter Richtung beaufschlagbar ist, je nachdem, ob der Leistungs-Feldeffekttransistor (24) ein- oder auszuschalten ist.

2. Schaltungsanordnung nach Anspruch 1, dadurch gekennzeichnet, daß parallel zu jeder Sekundärwicklung (11,12) des Übertragers (10) ein Widerstand (21,22) geschaltet ist.

3. Schaltungsanordnung nach einem der vorstehenden Ansprüche, dadurch gekennzeichnet, daß Feldeffekttransistoren als Treibertransistoren (16,20) eingesetzt sind.

4. Schaltungsanordnung nach einem der vorstehenden Ansprüche, dadurch gekennzeichnet, daß die Steuerelektroden (G) der Treibertransistoren (16;20) jeweils über

0245763

eine Serienschaltung aus einem Widerstand und zwei mit ihren Kathoden miteinander verbundene Zenerdioden (13,14,15; 17,18,19) an die Sekundärwicklungen (11,12) angeschlossen sind.

5. Schaltungsanordnung nach einem der vorstehenden Ansprüche, dadurch gekennzeichnet, daß die Primärwicklung (9) des Übertragers (10) eine mit Versorgungsspannung ($U_{S1}$) beaufschlagbare Mittelanzapfung aufweist.

6. Schaltungsanordnung nach Anspruch 5, dadurch gekennzeichnet, daß die beiden Enden der Primärwicklung (9) über zwei Hilfstransistoren (7,8) miteinander verbunden sind, wobei der gemeinsame Verbindungspunkt beider Transistoren (7,8) an der Versorgungsspannung ($U_{S1}$) liegt.

7. Schaltungsanordnung nach Anspruch 6, dadurch gekennzeichnet, daß der erste Hilfstransistor (7) über ein UND-Gatter (4) ansteuerbar ist.

8. Schaltungsanordnung nach Anspruch 6, dadurch gekennzeichnet, daß der zweite Hilfstransistor (8) über ein ODER-Gatter (5) ansteuerbar ist.

9. Schaltungsanordnung nach Anspruch 7, dadurch gekennzeichnet, daß ein erstes mit Zündsignalen (Z) beaufschlagbares monostabiles Kippglied (1) vorgesehen ist, das über ein zweites, Kurzimpulse abgebendes monostabiles Kippglied (2) mit einem ersten Eingang des UND-Gatters (4) verbunden ist.

10. Schaltungsanordnung nach Anspruch 7, dadurch gekennzeichnet, daß ein zweiter Eingang des UND-Gatters (4) mit einem Impulsfreigabesignal (F) beaufschlagbar ist.

**0245763**

11. Schaltungsanordnung nach Anspruch 8 und 9, dadurch gekennzeichnet, daß das erste monostabile Kippglied (1) über einen invertierenden Ausgang und ein drittes, Kurzimpulse abgebendes, monostabiles Kippglied (3) mit einem ersten Eingang des ODER-Gatters (5) verbunden ist.

12. Schaltungsanordnung nach Anspruch 8, dadurch gekennzeichnet, daß ein zweiter Eingang des ODER-Gatters (4) über ein viertes monostabiles Kippglied (6) mit negiertem Eingang mit einem Impulsfreigabesignal (F) beaufschlagbar ist.

13. Schaltungsanordnung nach einem der vorstehenden Ansprüche, dadurch gekennzeichnet, daß eine Zenerdiode (28) mit parallel geschaltetem Stützkondensator (34) mit ihrer Anode an Massepotential ($U_0$) und mit ihrer Kathode am Source-Anschluß (s) des Leistungs-Feldeffekttransistors (24) sowie über einen Widerstand (29) an der positiven Spannung ($U_+$) liegt.

Fig. 1

0245763

0245763

Fig. 2